# EUROPÄISCHE PATENTSCHRIFT

(11) **EP 2 142 935 B1**
(45) Veröffentlichungstag und Bekanntmachung des Hinweises auf die Patenterteilung: **25.08.2010**
(21) Anmeldenummer: 08759365.3
(22) Anmeldetag: 01.07.2008
(51) Int. Cl.: G01R 31/28

(54) **VERSCHLUSSMECHANISMUS FÜR DRUCKTESTKAMMERN ZUM TESTEN VON ELEKTRONISCHEN BAUELEMENTEN, INSBESONDERE IC'S**
CLOSURE MECHANISM FOR PRESSURE TEST CHAMBERS FOR TESTING ELECTRONIC COMPONENTS, IN PARTICULAR ICS
MÉCANISME DE FERMETURE POUR CHAMBRES D'ESSAI DE PRESSION POUR TESTER DES COMPOSANTS ÉLECTRONIQUES, EN PARTICULIER DES CIRCUITS INTÉGRÉS

(30) Priorität: 12.07.2007 DE 102007032559
(43) Veröffentlichungstag der Anmeldung: 13.01.2010
(73) Patentinhaber: Multitest elektronische Systeme GmbH, 83026 Rosenheim (DE)
(72) Erfinder: NAGY, Andreas, 81825 München (DE); SCHAULE, Maximilian, 87719 Mindelheim (DE); EIBL, Manfred, A-5112 Lamprechtshausen (AT); KURZ, Stefan, 83026 Rosenheim (DE)
(74) Vertreter: Bauer, Friedrich
(86) Internationale Anmeldenummer: PCT/EP2008/005368
(87) Internationale Veröffentlichungsnummer: WO 2009/007043

(56) Entgegenhaltungen:
- WO-A-01/42688
- DE-A1- 10 016 805
- DE-A1- 19 917 917
- DE-B- 1 177 882
- DE-C- 188 927
- DE-C- 870 621
- FR-A- 2 580 364
- GB-A- 1 229 489
- GB-A- 2 397 359
- JP-A- 2000 320 675
- US-A- 3 195 761
- US-A- 3 406 997
- US-A- 3 458 083

## Beschreibung

Die Erfindung betrifft einen Verschlussmechanismus für Drucktestkammern zum Testen von elektronischen Bauelementen, insbesondere IC's, unter bestimmten Druckbedingungen, gemäß dem Oberbegriff des Anspruches 1.

Elektronische Bauelemente wie beispielsweise MEMS (Micro-Electro-Mechanical-System), die zur Druckermittlung verwendet werden, werden üblicherweise nach ihrer Herstellung Drucktests unterworfen, um ihre ordnungsgemäße Funktion zu überprüfen oder deren Funktionskennlinie bei unterschiedlichen Temperaturen auszugleichen, d.h. zu kalibrieren. Hierzu ist es teilweise erforderlich, mehrere Parameter zu bestimmen. Die Drucktests finden in Drucktestkammern statt, die aus zwei voneinander trennbaren Kavitätselementen bestehen. Die zu testenden Bauelemente werden dabei in die Kavität eines Kavitätselements eingelegt, worauf dieses Kavitätselement dann gegen das andere Kavitätselement gefahren wird, bis es sich in dichter Anlage an diesem anderen Kavitätselement befindet. In diesem Zustand sind Kontaktstellen der Bauelemente mit elektrischen Kontakten verbunden, die zu einer elektronischen Testeinrichtung führen. Anschließend wird in der Kavität derjenige Druck erzeugt, bei dem die Tests durchgeführt werden sollen. Nach Beendigung der Tests werden die Kavitätselemente wieder auseinander gefahren, so dass die Bauelemente aus der Kavität entnommen und entsprechend dem Testergebnis sortiert werden können. Das Zuführen der Bauelemente in die Kavität und das Entnehmen der Bauelemente aus der Kavität erfolgt dabei zweckmäßigerweise mittels eines Handlers, d.h. eines Handhabungsautomaten, der das Be- und Entladen der Bauelemente mit hoher Geschwindigkeit durchführt.

Da die Tests häufig bei hohen Drücken von 20 bar oder mehr durchgeführt werden, ist es erforderlich, dass die Kavitätselemente mittels eines Verschlussmechanismus aneinander gehalten werden, der auch bei hohen Drücken die Dichtigkeit der Kavität gewährleistet, da andernfalls keine konstanten Druckbedingungen innerhalb der Kavität aufrechterhalten werden könnten. Darüber hinaus sollte ein derartiger Verschlussmechanismus einfach aufgebaut und für hohe Be- und Entladegeschwindigkeiten geeignet sein. Gängige Verschlussmechanismen genügen häufig nicht diesen Erfordernissen.

Der Erfindung liegt daher die Aufgabe zugrunde, einen Verschlussmechanismus für Drucktestkammern zum Testen von elektronischen Bauelementen, insbesondere IC's, zu schaffen, der auch bei hohen Drücken die Dichtigkeit der Kavität gewährleistet, einfach aufgebaut und für hohe Be- und Entladegeschwindigkeiten geeignet ist.

Diese Aufgabe wird erfindungsgemäß durch einen Verschlussmechanismus mit den Merkmalen des Anspruches 1 gelöst. Vorteilhafte Ausführungsformen der Erfindung sind in den weiteren Ansprüchen beschrieben.

Der erfindungsgemäße Verschlussmechanismus ist durch folgende Merkmale gekennzeichnet:
- der Verschlussmechanismus weist eine Mehrzahl von Schwenkbacken auf, die zwischen einer Verschlussstellung und einer Öffnungsstellung schwenkbar sind,
- zumindest ein Teil der Schwenkbacken weist mindestens eine Hubvorrichtung auf, die mittels der Schwenkbacken an eines der Kavitätselemente heranführbar ist, so dass dieses Kavitätselement in der Verschlussstellung der Schwenkbacken mittels der Hubvorrichtungen gegen das andere Kavitätselement drückbar ist,
- zumindest ein Teil der Schwenkbacken weist mindestens eine Verriegelungseinrichtung auf, mit der ein Abstandselement in einen Zwischenraum zwischen den Schwenkbacken und dem angedrückten Kavitätselement bewegbar ist, derart, dass das angedrückte Kavitätselement auch bei zurückgefahrener Hubvorrichtung in dichter Kontaktanlage am anderen Kavitätselement bleibt.

Mit dem erfindungsgemäßen Verschlussmechanismus können die beiden Kavitätselemente auf sehr sichere, einfache und schnelle Weise aneinander gedrückt und in dichtem Kontakt gehalten werden. Es ist möglich, eines der Kavitätselemente nach dem Beladen mit einem oder mehreren Bauelementen zunächst mit einer bekannten Vorrichtung sehr schnell in unmittelbare Nachbarschaft des anderen Kavitätselementes zu bringen. Anschließend werden die Schwenkbacken in ihre Verschlussstellung geschwenkt. Das weitere Andrücken des Kavitätselementes an das andere Kavitätselement übernehmen die Hubvorrichtungen, die zumindest in einem Teil der Schwenkbacken angeordnet sind. Da diese nur kleine Hubwege zurücklegen müssen, können diese entsprechend klein ausgebildet werden. Die auf das Kavitätselement aufzubringende Andrückkraft kann dabei durch Vorsehen einer entsprechenden Vielzahl von Hubvorrichtungen entsprechend aufgeteilt werden. Auf diese Weise wird ein Dichtring, der um die Kavität im Bereich des Spalts zwischen den beiden Kavitätselementen vorhanden ist, entsprechend zusammengedrückt. Durch das Einführen der Abstandselemente in den durch die Hubvorrichtungen erzeugten Zwischenraum zwischen angedrücktem Kavitätselement und Schwenkbacken wird die Andrückposition des Kavitätselements in jedem Fall soweit beibehalten, dass eine sichere Abdichtung zwischen den Kavitätselementen aufrechterhalten bleibt, auch wenn die Hubvorrichtungen zurückgefahren werden. Auf diese Weise muss der hohe Druck in den Hubvorrichtungen nicht während des gesamten Testvorgangs aufrechterhalten werden, sondern kann unmittelbar nach dem Einschieben der Abstandselemente sofort zurückgefahren werden.

Gemäß einer vorteilhaften Ausführungsform haben die Schwenkbacken eine C-, L- oder U-förmige Form. Auf diese Weise ist es möglich, die Schwenkbacken oberhalb des feststehenden Kavitätselements schwenkbar zu lagern und seitlich neben den Kavitätselementen derart entlangzuführen, dass die freien Enden der Schwenkbacken das bewegbare Kavitätselement hintergreifen.

Gemäß einer vorteilhaften Ausführungsform ist auf zwei gegenüberliegenden Seiten der Kavitätselemente jeweils ein Schwenkbacken angeordnet, an dem eine Mehrzahl von Hubvorrichtungen und Verriegelungseinrichtungen vorgesehen ist. In diesem Fall erstrecken sich die beiden Schwenkbacken zweckmäßigerweise über den überwiegenden Teil der Länge oder über die gesamte Länge der Kavitätselemente, wobei dann die Hubvorrichtungen und Verriegelungseinrichtungen abwechselnd nebeneinander angeordnet sein können. Die Anzahl der Hubvorrichtungen und Verriegelungseinrichtungen hängt von der Größe der Kavitätselemente und von den Testdrücken innerhalb der Kavität ab und kann beispielsweise sechs bis zehn oder mehr Hubvorrichtungen und Verriegelungseinrichtungen pro Schwenkbacken betragen.

Gemäß einer alternativen Ausführungsform sind auf zwei gegenüberliegenden Seiten der Kavitätselemente jeweils mindestens zwei Schwenkbacken angeordnet, wobei benachbarte Schwenkbacken abwechselnd eine Hubvorrichtung bzw. Verriegelungseinrichtung aufweisen. Die Anzahl der Schwenkbacken kann jedoch in weitem Umfang variieren und insbesondere dann, wenn Tests bei hohen Drücken durchgeführt werden, auch wesentlich größer sein, beispielsweise sechs bis zehn oder mehr Schwenkbacken auf jeder Seite umfassen.

Gemäß einer vorteilhaften Ausführungsform weist die Hubvorrichtung einen Stößel auf, der in einem das anzudrückende Kavitätselement hintergreifenden Stützabschnitt des Schwenkbackens geführt und in Andrückrichtung bewegbar ist. Ein derartiger Stößel kann auf vielfältige Weise betätigt werden, beispielsweise über einen Hebelmechanismus, der pneumatisch, hydraulisch oder elektromechanisch betätigt wird.

Gemäß einer vorteilhaften Ausführungsform ist der Stößel über einen Hebelmechanismus mit einem Antrieb in Wirkverbindung, der innerhalb des Schwenkbackens angeordnet ist. Zweckmäßigerweise besteht ein derartiger Antrieb aus einem pneumatisch oder hydraulisch bewegbaren Kolben. In diesem Fall sind sämtliche bewegbaren Elemente der Hubvorrichtung innerhalb des zugeordneten Schwenkbackens angeordnet, so dass zwischen dem beweglichen Schwenkbacken und der stationären Umgebung lediglich eine Fluidversorgungsleitung vorgesehen werden muss.

Gemäß einer vorteilhaften Ausführungsform umfasst die Verriegelungseinrichtung ein Abstandsplättchen, das senkrecht zur Andrückrichtung in den Zwischenraum zwischen Schwenkbacken und Kavitätselement einführbar ist. Bevorzugt weist die Verriegelungseinrichtung ein im oder am Schwenkhebel gelagertes Antriebszahnrad auf, das mit einem Zahnstangenabschnitt des Abstandsplättchens zusammenwirkt. Eine derartige Verriegelungseinrichtung lässt sich auf relativ einfache Weise realisieren, benötigt wenig Platz und ermöglicht ein sicheres mechanisches Verriegeln des angedrückten Kavitätselements in seiner angedrückten dichten Position.

Gemäß einer vorteilhaften Ausführungsform ist an den Schwenkhebeln jeweils ein Gegendruckelement befestigt, das in der Verschlussstellung der Schwenkhebel an demjenigen Kavitätselement, das von den Hubeinrichtungen nicht kontaktiert wird, anliegt, derart, dass dieses Kavitätselement gegen die von den Hubeinrichtungen erzeugte Andrückkraft abgestützt wird. Auf diese Weise können die Andrückkräfte, die von den Hubeinrichtungen erzeugt und von den Verriegelungseinrichtungen aufrechterhalten werden, von den Gegendruckelementen aufgenommen werden, so dass es nicht erforderlich ist, dasjenige Kavitätselement, das von den Hubeinrichtungen nicht kontaktiert wird, über zusätzliche, separate Vorrichtungen abzustützen.

Die Erfindung wird nachfolgend anhand der Zeichnungen beispielhaft näher erläutert. Es zeigen:
- Figur 1 :: eine schematische, teilsweise geschnittene Ansicht zweier Kavitätselemente mit einem erfindungsgemäßen Verschlussmechanismus, wobei sich die Schwenkbacken in einer Öff- nungsstellung befinden,
- Figur 2 :: eine schematische Ansicht der Kavitäts- elemente und des Verschlussmechanismus von Figur 1, wobei sich die Schwenkbacken in einer geschlossenen Stellung befinden,
- Figur 3 :: einen Teil der Kavitätselemente und eines Schwenkhebels mit schematisch dargestell- ter Hubvorrichtung, wobei sich die Hubvor- richtung in einer zurückgefahrenen Aus- gangsstellung befindet,
- Figur 4 :: eine Darstellung entsprechend Figur 3, wobei sich die Hubvorrichtung in einer ausgefahrenen Stellung befindet,
- Figur 5 :: eine schematische Darstellung eines Teils der Kavitätselemente und eines Schwenkba- ckens mit einer Verriegelungseinrichtung, die sich in einer zurückgezogenen Aus- gangsstellung befindet,
- Figur 6 :: eine Darstellung entsprechend Figur 5, wobei sich die Verriegelungseinrichtung in einer vorgeschobenen Eingriffsstellung be- findet, und
- Figur 7 :: die Verriegelungseinrichtung von Figur 6 in einer etwas detaillierten Darstellung.

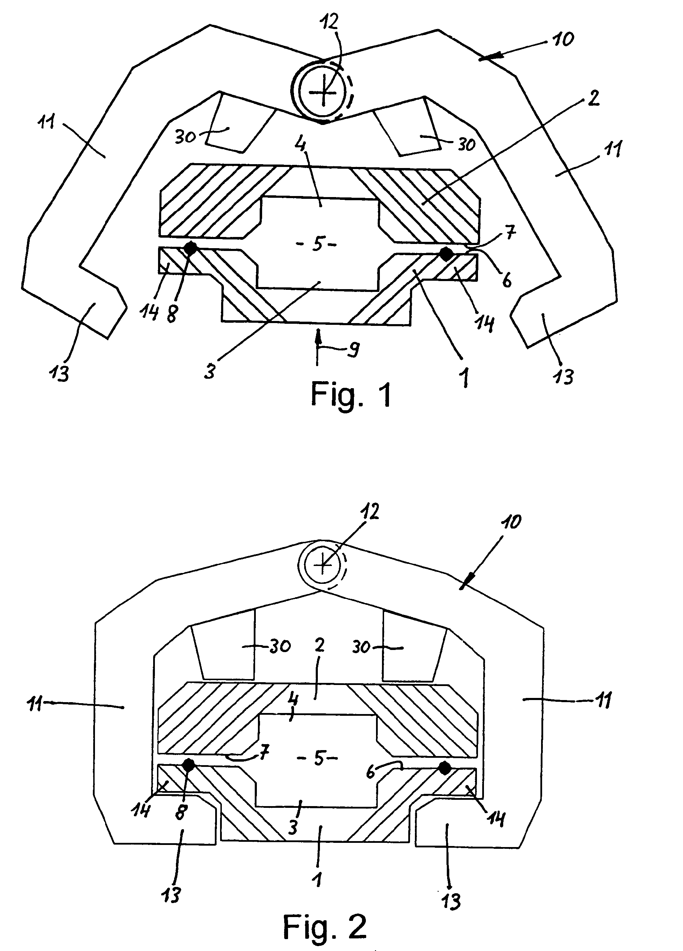

In den Figuren 1 und 2 ist in schematisierter, vereinfachter Form ein Schnitt durch ein erstes Kavitätselement 1 und ein zweites Kavitätselement 2 dargestellt. Die beiden Kavitätselemente 1, 2 haben in der Draufsicht zumindest im Wesentlichen eine rechteckige Form. In einem zentralen Bereich des ersten Kavitätselements 1 ist eine Vertiefung 3 vorgesehen, in die ein oder mehrere, nicht dargestellte elektronische Bauelemente eingesetzt werden können, wenn sich das erste Kavitätselement 1 in ausreichendem Abstand zum zweiten Kavitätselement 2 befindet.

In einem zentralen Bereich des zweiten Kavitätselements 2 ist eine Vertiefung 4 vorgesehen, die der Vertiefung 3 des ersten Kavitätselements 1 gegenüberliegt und zusammen mit dieser eine geschlossene Kavität 5 bildet, wenn das erste Kavitätselement 1 an das zweite Kavitätselement 2 herangefahren wird.

Die Kavitätselemente 1, 2 weisen einander zugewandte Flächen 6, 7 auf, die parallel zueinander und im dargestellten Ausführungsbeispiel eben ausgebildet sind. In der Fläche 6 des Kavitätselements 1 ist ein um die Vertiefung 3 herum laufender Dichtring 8 eingebettet, der über die Fläche 6 vorsteht. Wird das erste Kavitätselement 1 gegen das zweite Kavitätselement 2 gedrückt, verformt sich der Dichtring 8 elastisch und sorgt für eine Abdichtung der Kavität 5.

Im Bereich der Vertiefung 4 weist das zweite Kavitätselement 2 nicht dargestellte elektrische Kontakte auf, die mit den entsprechenden Kontakten der in die Vertiefung 3 eingelegten Bauelemente in Kontakt gebracht werden, wenn die beiden Kavitätselemente 1, 2 zusammengefahren werden. Weiterhin münden nicht dargestellte Luft- bzw. Gasleitungen - vorzugsweise über das Kavitätselement 2 - in die Kavität 5, um innerhalb der Kavität 5 vorbestimmte Drücke zu erzeugen, bei denen die Bauelemente getestet werden sollen.

Nachdem Beladen des Kavitätselements 1 wird dieses mittels einer nicht dargestellten Vorrichtung in Richtung des Pfeils 9 bewegt und damit an das zweite Kavitätselement 2, das stationär gehalten wird, bis in die in den Figuren 1 und 2 gezeigte Stellung angenähert, in der sich der Dichtring 8 in Nachbarschaft zur Fläche 7 des Kavitätselements 2 befindet. In dieser angenäherten Position haben die Kontakte der Bauelemente noch keinen Kontakt mit den gegenüberliegenden Kontakten des zweiten Kavitätselements 2, befinden sich jedoch in unmittelbarer Nachbarschaft zu diesen.

Aus den Zeichnungen ist weiterhin ein Verschlussmechanismus 10 ersichtlich, mit dem das untere Kavitätselement 1 aus der in den Figuren 1 und 2 dargestellten angenäherten Stellung weiterhin in Richtung des oberen Kavitätselementes 2 gedrückt werden kann, bis der Dichtring 8 in dichter Anlage am oberen Kavitätselement 2 liegt und die Kontakte der zu testenden Bauelemente mit den entsprechenden Kontakten des oberen Kavitätselements 2 kontaktiert sind.

Dieser Verschlussmechanismus 10 weist zwei gegenüberliegende Schwenkbacken 11 auf, welche die beiden Kavitätselemente 1, 2 von gegenüberliegenden Seiten her umgreifen und diese zusammendrücken, wie nachfolgend noch näher erläutert wird. In den Figuren 1 und 2 sind lediglich zwei Schwenkbacken 11 schematisch dargestellt, die um eine gemeinsame horizontale Schwenkachse 12 schwenkbar sind. Alternativ können jedoch auf beiden Seiten der Kavitätselemente 1, 2 mehrere Schwenkbacken 11 vorzugsweise regelmäßig beabstandet nebeneinander angeordnet sein, um die Andrückkräfte möglichst gleichmäßig auf die Kavitätselemente 1, 2 zu verteilen. Weiterhin ist es auch keineswegs erforderlich, dass die linksseitigen und rechtsseitigen Schwenkbacken 11 um eine gemeinsame Schwenkachse 12 schwenkbar sind. Vielmehr können die linksseitigen und rechtsseitigen Schwenkbacken 11 jeweils um eine eigene Schwenkachse schwenkbar sein, wobei die beiden Schwenkachsen dann parallel zueinander angeordnet sind.

Die Schwenkachse 12 befindet sich im dargestellten Ausführungsbeispiel oberhalb des oberen Kavitätselements 2. Die Schwenkbacken 11 sind C-förmig ausgebildet und erstrecken sich von der Schwenkachse 12 links- und rechtsseitig nach unten. An ihrem unteren Ende weisen die Schwenkbacken 11 sich nach innen, d.h. aufeinander zu, erstreckende Stützabschnitte 13 auf. In der auseinandergeschwenkten Stellung der Schwenkbacken 11, die in Figur 1 gezeigt ist, sind die Stützabschnitte 13 soweit voneinander beabstandet, dass das Kavitätselement 1 in und entgegen der Richtung des Pfeils 9 bewegt werden kann, ohne an den Stützabschnitten 13 anzustoßen. Werden die Schwenkbacken 11 dagegen nach innen, d.h. aufeinanderzu, in die in Figur 2 gezeigte Verschlussstellung geschwenkt, hintergreifen die Stützabschnitte 13 die beiden gegenüberliegenden Randabschnitte 14 des unteren Kavitätselementes 1, wenn sich dieses relativ zum oberen Kavitätselement 2 in der angenäherten Stellung befindet, die in den Figuren 1 und 2 dargestellt ist.

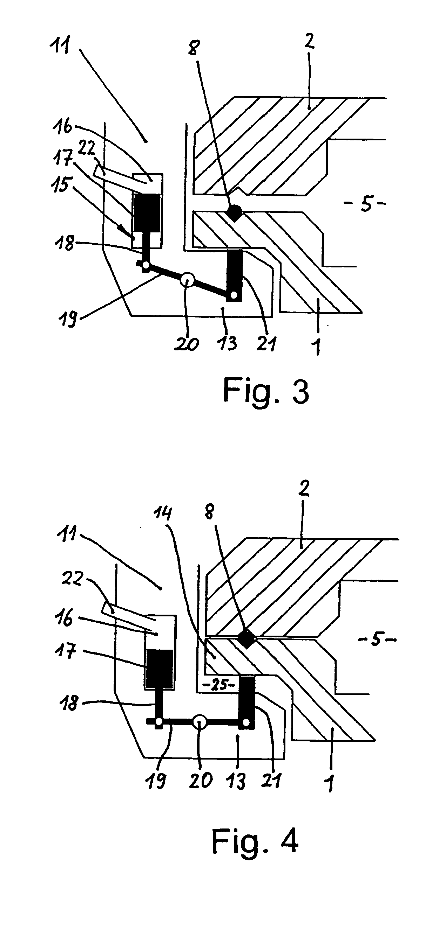

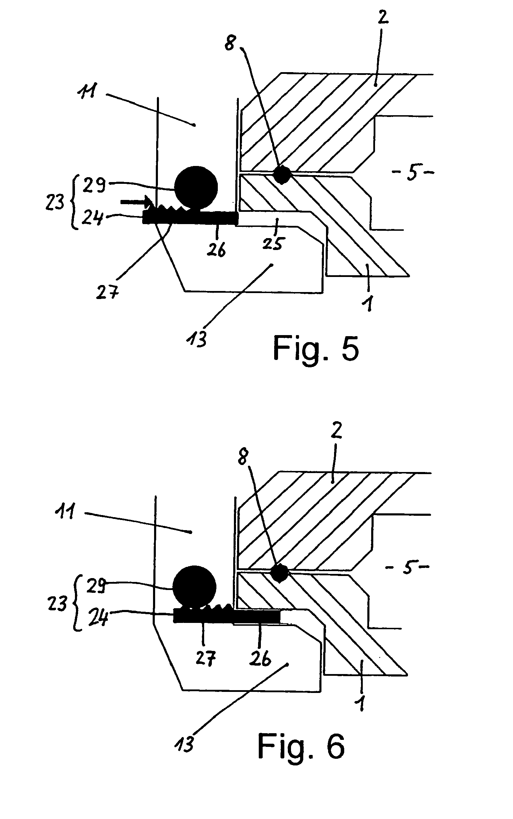

Um das untere Kavitätselement 1 von dieser angenäherten Stellung weiter gegen das obere Kavitätselement 2 zu drücken, sind sowohl im links- als auch rechtsseitigen Schwenkbacken 11 mehrere gleiche Hubvorrichtungen 15 längs der Schwenkbacken 11 angeordnet, wobei in den Figuren 4 und 5 nur eine dieser Hubvorrichtungen 15 dargestellt ist.

Die Hubvorrichtung 15 umfasst einen im vertikalen Abschnitt des Schwenkbackens 11 angeordneten Zylinder 16, in dem ein pneumatisch oder hydraulisch betätigbarer Kolben 17 auf- und abbewegbar ist. Die Kolbenstange 18 des Kolbens 17 ist an einem Schwenkhebel 19 angelenkt, der um eine Schwenkachse 20 schwenkbar ist. Das gegenüberliegende Endes des Schwenkhebels 19 ist wiederum an einem Stößel 21 angelenkt, der innerhalb des Stützabschnitts 13 des Schwenkbackens 11 verschiebbar geführt und in vertikaler Richtung auf- und abbewegbar ist. Wird der Kolben 17, wie in Figur 3 dargestellt, bis in seine obere Stellung bewegt, wird der Stößel 21 durch den Schwenkhebel 19 in seine zurückgezogene Position bewegt, in der das obere Ende des Stößels 21 nicht oder nur geringfügig über den Stützabschnitt 13 nach oben vorsteht. In jedem Fall befindet sich der Stößel 21 in dieser zurückgezogenen Position in einer Stellung, in der er das Verschwenken der Schwenkbacken 11 von ihrer Öffnungsstellung in ihre Verschlussstellung und umgekehrt nicht behindert.

Wird in einem Zylinder 16 über eine Fluidleitung 22 Fluid eingeführt, bewegt sich der Kolben 17 in eine untere Stellung, wie in Figur 4 dargestellt. Hierdurch wird der Stößel 21 über den Schwenkhebel 19 nach oben vorgeschoben, wodurch er mit der Unterseite des Randabschnitts 14 des unteren Kavitätselements 1 in Kontakt gelangt und das Kavitätselement 1 soweit nach oben gegen das Kavitätselement 2 gedrückt, bis der Dichtring 8 stark zusammengedrückt ist. In dieser Stellung ist die Kavität 5 nach außen hin völlig abgedichtet. Weiterhin bewirken die Stößel 21 eine selbsthemmende Klemmung, die verhindert, dass sich die Schwenkbacken 11 in unerwünschter Weise öffnen.

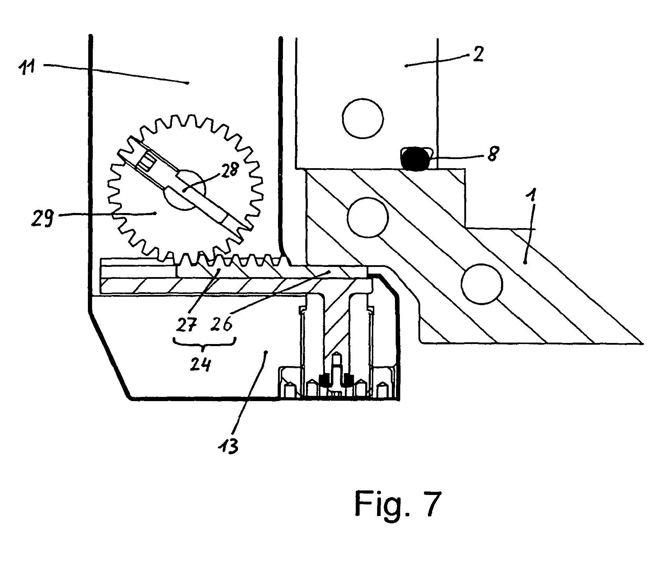

Um den hohen Anpressdruck nicht während des gesamten Testvorgangs über die Hubvorrichtungen 15 aufbringen zu müssen und diese zu entlasten, weisen sowohl die links- als auch rechtsseitigen Schwenkbacken 11 mehrere gleiche mechanische Verriegelungseinrichtungen 23 auf, die längs der Schwenkbacken 11 zwischen den Hubvorrichtungen 15 angeordnet sind. Anhand der Figuren 5 und 7 wird eine dieser Verriegelungseinrichtungen 23 näher erläutert.

Jede Verriegelungseinrichtung 23 umfasst ein Abstandsplättchen 24, das in den Zwischenraum 25 zwischen der Unterseite des durch die Hubvorrichtungen 15 angepressten Kavitätselements 1 (Figur 4) und der Oberseite der Stützabschnitte 13 der Schwenkbacken 11 eingeschoben werden kann. Die Verschieberichtung der Abstandsplättchen 24 verläuft somit quer zum Kavitätselement 1 und damit senkrecht zur Bewegungsrichtung des Kavitätselements 1.

Jedes Abstandsplättchen 24 weist einen vorderen ebenen Abschnitt 26 und einen hinteren Zahnstangenabschnitt 27 auf. Der ebene Abschnitt 26 ist nur geringfügig dünner als die Höhe des Zwischenraums 25 (Figur 4). Der Zahnstangenabschnitt 27 wirkt mit einem Antrieb zusammen, der im gezeigten Ausführungsbeispiel aus einem um eine Drehachse 28 drehbaren Antriebszahnrad 29 besteht (Figur 7). Das Abstandsplättchen 24 kann mittels des Antriebszahnrads 29 von einer hinteren, zurückgezogenen Stellung, die in Figur 5 schematisch darstellt ist, in den Zwischenraum 25 und damit in eine Verriegelungsstellung vorgeschoben werden, die in Figur 6 schematisch dargestellt ist. Werden nun die Stößel 21 der Hubvorrichtungen 15 zurückgefahren, kann sich das untere Kavitätselement 1 aufgrund der Abstandsplättchen 24 nur noch ganz wenig vom oberen Kavitätselement 2 wegbewegen, wobei der Dichtring 8 soweit gedrückt bleibt, dass die Kavität 5 in der gewünschten Weise abgedichtet bleibt.

Weiterhin stellen die Abstandsplättchen 24 eine mechanische Klemmvorrichtung dar, die verhindert, dass sich die Schwenkbacken 11 in unerwünschter Weise öffnen.

Um das obere Kavitätselement 2 gegen den Anpressdruck des unteren Kavitätselements 1 abzustützen, weisen die Schwenkbacken 11 jeweils ein Gegendruckelement 30 auf, das in den Figuren 1 und 2 schematisch dargestellt ist. Die Gegendruckelemente 30 bestehen aus Stützelementen, die von einem oberen Schenkel der Schwenkbacken 11 nach unten vorstehen und beim Schließen der Schwenkbacken 11 mit der Oberseite des oberen Kavitätselements 2 in Kontakt gelangen.

Auf diese Weise können die Andrückkräfte, die über die Stößel 21 der Hubvorrichtungen 15, mittels der Abstandsplättchen 24 und durch die Drücke innerhalb der Kavität 5 während der Tests auf das obere Kavitätselement 2 einwirken, von den Gegendruckelementen 30 und damit ebenfalls von den Schwenkbacken 11 aufgenommen werden.

Nach Beendigung des Testvorgangs wird der Druck in der Kavität 5 abgebaut. Anschließend werden die Stößel 21 ausgefahren, um das untere Kavitätselement 1 kurzzeitig stärker gegen das obere Kavitätselement 2 zu pressen, so dass die Abstandsplättchen 24 in die in Figur 5 gezeigte Stellung zurückgezogen werden können, in der sie nicht oder nur unwesentlich nach innen über die Schwenkbacken 11 vorstehen. Nachdem die Stößel 21 in die zurückgezogene Stellung zurückbewegt worden sind, können anschließend die Schwenkbacken 11 ungehindert nach außen in die in Figur 1 gezeigte Öffnungsstellung zurückgeschwenkt werden. Das untere Kavitätselement 1 kann nun nach unten abgesenkt werden, so dass die getesteten Bauelemente entnommen und noch nicht getestete Bauelemente in die Vertiefung 3 eingelegt werden können.

## Patentansprüche

1. Verschlussmechanismus für Drucktestkammern zum Testen von elektronischen Bauelementen, insbesondere IC's, unter bestimmten Druckbedingungen, wobei die Drucktestkammer zwei Kavitätselemente (1, 2) aufweist, die in eine zusammengefahrene Position bringbar sind, in der sie eine Kavität (5) dicht umschließen, mit:
- einer Mehrzahl von Schwenkbacken (11), die zwischen einer Verschlussstellung und einer Öffnungsstellung schwenkbar sind,
- Abstandselementen, die bei sich in der zusammengefahrenen Position befindenden Kavitätselementen (1, 2) in einem Zwischenraum zwischen den Schwenkbacken (11) und einem Kavitätselement (1) bewegbar sind,
- Verriegelungseinrichtungen (23), mit denen die Abstandselemente bewegbar sind,
**gekennzeichnet durch** die weiteren Merkmale:
- zumindest ein Teil der Schwenkbacken (11) weist mindestens eine Hubvorrichtung (15) auf, die mittels der Schwenkbacken (11) an eines der Kavitätselemente (1, 2) heranführbar ist, so dass dieses Kavitätselement (1) in der Verschlussstellung der Schwenkbacken (11) mittels der Hubvorrichtung (15) gegen das andere Kavitätselement (2) drückbar ist,
- zumindest ein Teil der Schwenkbacken (11) weist mindestens eine Verriegelungseinrichtung (23) auf, mit der ein Abstandselement in den Zwischenraum zwischen den Schwenkbacken (11) und dem angedrückten Kavitätselement (1) einführbar ist, derart, dass das angedrückte Kavitätselement (1) auch bei zurückgefahrener Hubvorrichtung (15) in der zusammengefahrenen Position bleibt.

2. Verschlussmechanismus nach Anspruch 1, **dadurch gekennzeichnet, dass** die Schwenkbacken (11) eine C-, L- oder U-förmige Form haben.

3. Verschlussmechanismus nach Anspruch 1 oder 2, **dadurch gekennzeichnet, dass** auf zwei gegenüberliegenden Seiten der Kavitätselemente (1, 2) jeweils ein Schwenkbacken (11) angeordnet ist, an dem eine Mehrzahl von Hubvorrichtungen (15) und Verriegelungseinrichtungen (23) vorgesehen ist.

4. Verschlussmechanismus nach Anspruch 1 oder 2, **dadurch gekenntzeichnet, dass** auf zwei gegenüberliegenden Seiten der Kavitätselemente (1, 2) jeweils mindestens zwei Schwenkbacken (11) angeordnet sind, wobei benachbarte Schwenkbacken (11) abwechselnd eine Hubvorrichtung (15) bzw. Verriegelungseinrichtung (23) aufweisen.

5. Verschlussmechanismus nach einem der vorhergehenden Ansprüche, **dadurch gekennzeichnet, dass** die Hubvorrichtung (15) einen Stößel (21) aufweist, der in einem das anzudrückende Kavitätselement (1) hintergreifenden Stützabschnitt (13) des Schwenkbackens (11) geführt und in Andrückrichtung bewegbar ist.

6. Verschlussmechanismus nach Anspruch 5, **dadurch gekennzeichnet, dass** der Stößel (21) über einen Hebelmechanismus mit einem Antrieb in Wirkverbindung ist, der innerhalb des Schwenkbackens (11) angeordnet ist.

7. Verschlussmechanismus Anspruch 6, **dadurch gekennzeichnet, dass** der Antrieb aus einem pneumatisch oder hydraulisch bewegbaren Kolben (17) besteht.

8. Verschlussmechanismus nach einem der vorhergehenden Ansprüche, **dadurch gekennzeichnet, dass** die Verriegelungseinrichtung (23) ein Abstandsplättchen (24) umfasst, das senkrecht zur Andrückrichtung in den Zwischenraum (25) zwischen Schwenkbacken (11) und Kavitätselement (1) einführbar ist.

9. Verschlussmechanismus nach Anspruch 8, **dadurch gekennzeichnet, dass** die Verriegelungseinrichtung (23) ein im oder am Schwenkhebel (11) gelagertes Antriebszahnrad (29) aufweist, das mit einem Zahnstangenabschnitt (27) des Abstandsplättchens (24) zusammenwirkt.

10. Verschlussmechanismus nach einem der vorhergehenden Ansprüche, **dadurch gekennzeichnet, dass** an den Schwenkhebeln (11) jeweils ein Gegendruckelement (30) befestigt ist, das in der Verschlussstellung der Schwenkbacken (11) an demjenigen Kavitätselement (2), das von den Hubeinrichtungen (15) nicht kontaktiert wird, anliegt, derart, dass dieses Kavitätselement (2) entgegen der von den Hubeinrichtungen (15) erzeugten Andrückkraft abgestützt wird.

## Claims

1. Closure mechanism for pressure test chambers for testing electronic components, in particular ICs, under specific pressure conditions, the pressure test chamber having two cavity members (1, 2) which can be brought into a converged position in which they enclose a cavity (5) in a tight manner, comprising:
- a plurality of pivoting jaws (11) which can be pivoted between a closed position and an open position,
- spacer members which can be moved into a gap between the pivoting jaws (11) and a cavity member (1) when the cavity members (1, 2) are in the converged position,
- locking means (23), with which the spacer members can be moved,
**characterised by** the following features:
- at least a part of the pivoting jaws (11) has at least one lifting device (15) which can be advanced towards one of the cavity members (1, 2) by the pivoting jaws (11) so as to be able to press said cavity member (1) against the other cavity member (2) by means of the lifting device (15) in the closed position of the pivoting jaws (11),
- at least a part of the pivoting jaws (11) has at least one locking means (23) with which a spacer member can be moved into the gap between the pivoting jaws (11) and the pressed cavity member (1) in such a way that the pressed cavity member (1) remains in the converged position even when the lifting device (15) has been retracted.

2. Closure mechanism according to claim 1, **characterised in that** the pivoting jaws (11) are C-, L- or U-shaped.

3. Closure mechanism according to either claim 1 or claim 2, **characterised in that** a pivoting jaw (11), on which a plurality of lifting devices (15) and locking means (23) is provided, is arranged on each of two opposite sides of the cavity members (1, 2).

4. Closure mechanism according to either claim 1 or claim 2, **characterised in that** at least two pivoting jaws (11) are arranged on each of two opposite sides of the cavity members (1, 2), adjacent pivoting jaws (11) alternately comprising a lifting device (15) or locking means (23).

5. Closure mechanism according to any one of the preceding claims, **characterised in that** the lifting device (15) comprises a plunger (21), said plunger being guided in a support portion (13), which engages from behind the cavity member (1) to be pressed, of the pivoting jaw (11) and being movable in the pressing direction.

6. Closure mechanism according to claim 5, **characterised in that** the plunger (21) is functionally connected via a lever mechanism to a drive means arranged within the pivoting jaw (11).

7. Closure mechanism claim 6, **characterised in that** the drive means is formed from a pneumatically or hydraulically displaceable piston (17).

8. Closure mechanism according to any one of the preceding claims, **characterised in that** the locking means (23) comprises a small spacer plate (24) which can be inserted perpendicular to the pressing direction into the gap (25) between the pivoting jaw (11) and the cavity member (1).

9. Closure mechanism according to claim 8, **characterised in that** the locking means (23) comprises a driving toothed wheel (29) which is mounted in or on the pivoting jaw (11) and cooperates with a toothed rack portion (27) of the small spacer plate (24).

10. Closure mechanism according to any one of the preceding claims, **characterised in that** a counter-pressure member (30) is fastened to each pivoting jaw (11) and, in the closed position of the pivoting jaw (11), contacts the cavity member (2) not contacted by the lifting devices (15) in such a way that this cavity member (2) is supported against the pressing force produced by the lifting devices (15).

## Revendications

1. Mécanisme de fermeture pour des chambres d'essai sous pression destinées à tester des composants électroniques, en particulier des circuits intégrés, sous des conditions de pression déterminées, dans lequel la chambre d'essai sous pression comprend deux éléments de cavité (1, 2) qui peuvent être amenés dans une position regroupée dans laquelle ils enferment de façon étanche une cavité (5), comprenant :
- une pluralité de mâchoires pivotantes (11) qui peuvent être pivotées entre une position de fermeture et une position d'ouverture,
- des éléments d'écartement qui, lorsque les éléments de cavité (1, 2) se trouvent dans la position regroupée, sont déplaçables dans un espace intermédiaire entre les mâchoires pivotantes (11) et un élément de cavité (1),
- des moyens de verrouillage (23) avec lesquels les éléments d'écartement sont déplaçables,
**caractérisé par** les autres caractéristiques :
- au moins une partie des mâchoires pivotantes (11) comprend au moins un dispositif de levage (15), lequel peut être approché de l'un des éléments de cavité (1, 2) au moyen des mâchoires pivotantes (11), de sorte que cet élément de cavité (1) est susceptible d'être poussé, dans la position de fermeture des mâchoires pivotantes (11), au moyen du dispositif de levage (15) contre l'autre élément de cavité (2),
- au moins une partie des mâchoires pivotantes (11) comprend au moins un dispositif de verrouillage (23) avec lequel un élément d'écartement peut être introduit dans l'espace intermédiaire entre les mâchoires pivotantes (11) et l'élément de cavité (1) poussé, de telle façon que l'élément de cavité (1) poussé demeure dans la position regroupée même lorsque le dispositif de levage (15) est rétracté.

2. Mécanisme de fermeture selon la revendication 1, **caractérisé en ce que** les mâchoires pivotantes (11) ont une forme en C, en L ou en U.

3. Mécanisme de fermeture selon la revendication 1 ou 2, **caractérisé en ce qu'**une mâchoire pivotante (11) est agencée respectivement sur deux côtés opposés des éléments de cavité (1, 2), mâchoire sur laquelle sont prévus une pluralité de dispositifs de levage (15) et de dispositifs de verrouillage (23).

4. Mécanisme de fermeture selon la revendication 1 ou 2, **caractérisé en ce qu'**au moins deux mâchoires pivotantes (11) sont agencées respectivement sur deux côtés opposés des éléments de cavité (1, 2), de sorte que des mâchoires pivotantes voisines (11) comprennent alternativement un dispositif de levage (15) ou respectivement un dispositif de verrouillage (23).

5. Mécanisme de fermeture selon l'une des revendications précédentes, **caractérisé en ce que** le dispositif de levage (15) comprend un poussoir (21) qui est guidé dans un tronçon de soutien (13), qui engage par l'arrière l'élément de cavité (1) à pousser, de la mâchoire pivotante (11) et qui est déplaçable dans la direction de poussée.

6. Mécanisme de fermeture selon la revendication 5, **caractérisé en ce que** le poussoir (21) est en liaison d'action via un mécanisme à levier avec un entraînement, lequel est agencé à l'intérieur de la mâchoire pivotante (11).

7. Mécanisme de fermeture selon la revendication 6, **caractérisé en ce que** l'entraînement est un piston déplaçable par voie pneumatique ou hydraulique (17).

8. Mécanisme de fermeture selon l'une des revendications précédentes, **caractérisé en ce que** le dispositif de verrouillage (23) comprend une plaquette d'écartement (24), laquelle peut être introduite perpendiculairement à la direction de poussée dans l'espace intermédiaire (25) entre la mâchoire pivotante (11) et l'élément de qualité (1).

9. Mécanisme de fermeture selon la revendication 8, **caractérisé en ce que** le dispositif de verrouillage (23) comprend un engrenage d'entraînement (29) monté dans ou sur le levier pivotant (11), qui coopère avec un tronçon de crémaillère (27) de la plaquette d'écartement (24).

10. Mécanisme de fermeture selon l'une des revendications précédentes, **caractérisé en ce qu'**un élément de contrepression (30) est fixé sur chaque levier pivotant (11), élément qui, dans la position de fermeture des mâchoires pivotantes (11), s'applique contre l'élément de cavité (2) qui n'est pas en contact avec les dispositifs de levage (15), de telle façon que cet élément de cavité (2) est soutenu à l'encontre de la force de poussée engendrée par les dispositifs de levage (15).
